**Europäisches Patentamt**

**European Patent Office**

**Office européen des brevets**

(11) Veröffentlichungsnummer: **0 107 034**
A2

# EUROPÄISCHE PATENTANMELDUNG

(21) Anmeldenummer: **83109279.6**

(22) Anmeldetag: **19.09.83**

(51) Int. Cl.³: **H 01 J 37/28**, H 01 J 37/22

(30) Priorität: **24.09.82 DE 3235449**

(43) Veröffentlichungstag der Anmeldung: **02.05.84**
**Patentblatt 84/18**

(84) Benannte Vertragsstaaten: **DE GB NL**

(71) Anmelder: **SIEMENS AKTIENGESELLSCHAFT, Berlin und München Wittelsbacherplatz 2, D-8000 München 2 (DE)**

(72) Erfinder: **Feuerbaum, Hans-Peter, Dr., Dipl.-Phys., Arno-Assmann-Strasse 14, D-8000 München 83 (DE)**

(54) **Flying-Spot Scanner für lichtmikroskopische Untersuchungen in einem Raster-Elektronenmikroskop und Verfahren zu seinem Betrieb.**

(57) Eine Vorrichtung soll angegeben werden, mit der ein marktübliches Raster-Elektronenmikroskop in einer weiteren Betriebsart betrieben werden kann. Bei einem Flying-Spot Scanner für lichtmikroskopische Untersuchungen ist der Elektronenstrahl (R) eines Raster-Elektronenmikroskops auf einen Szintillator (S) gerichtet. Dabei ist das vom Szintillator (S) emittierte Licht (L) über ein optisches System (O) auf einen zu untersuchenden Prüfpunkt (IC) abgebildet.

SIEMENS AKTIENGESELLSCHAFT
Berlin und München

Unser Zeichen

VPA 82 P 1 8 3 8 E

0107034

Flying-Spot Scanner für lichtmikroskopische Untersuchungen in einem Raster-Elektronenmikroskop und Verfahren zu seinem Betrieb.

Die Erfindung betrifft einen Flying-Spot Scanner für lichtmikroskopische Untersuchungen nach dem Oberbegriff des Anspruchs 1 und ein Verfahren zum Betrieb eines solchen Flying-Spot Scanners.

Das Raster-Elektronenmikroskop ist aufgrund der verschiedenen bei ihm möglichen Betriebsarten ein wichtiges Hilfsmittel bei der Fehleranalyse und bei der Funktionsprüfung von integrierten Schaltungen.

Der Erfindung liegt die Aufgabe zugrunde, eine Vorrichtung anzugeben, mit der ein Raster-Elektronenmikroskop in einer weiteren Betriebsart betrieben werden kann.

Diese Aufgabe wird erfindungsgemäß durch einen Flying-Spot Scanner für lichtmikroskopische Untersuchungen nach dem Anspruch 1 gelöst.

Dabei werden die Wechselwirkungsprodukte detektiert, die ein fokussierter Lichtstrahl auslöst. Die Erfindung erlaubt es, den Anwendungsbereich eines Raster-Elektronenmikroskops mir nur geringem Aufwand auf den eines Laser Scanners auszudehen. So erlaubt eine erfindungsgemäße neue Betriebsart des Raster-Elektronenmikroskops die Induzierung von Strömen in integrierten Schaltungen durch Licht. Eine erfindungsgemäße neue Betriebsart ermöglicht damit eine Fehleranalyse ähnlich einem EBIC-Verfahren. Bei einer erfindungsgemäßen neuen Betriebs-

My 1 Bla / 8.9.1982

0107034
82 P 1838 E

art des Raster-Elektronenmikroskops treten jedoch keine Bestrahlungsschäden auf.

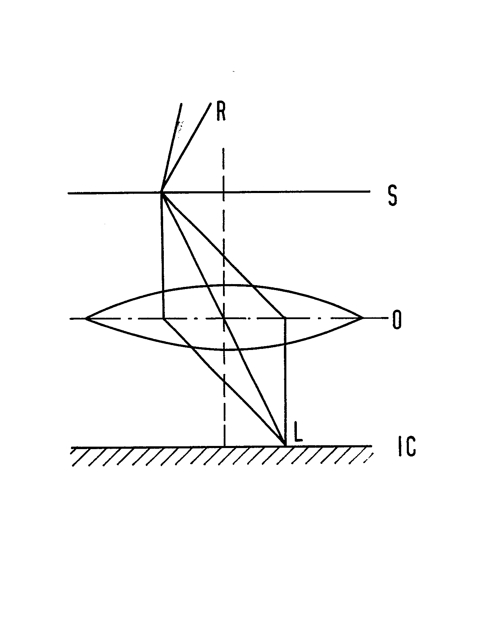

Weitere Ausgestaltungen und Vorteile der Erfindung sind in den Unteransprüchen, der Beschreibung und der Zeichnung dargestellt.

Das der Erfindung zugrundeliegende Prinzip des Flying-Spot Scanners für lichtmikroskopische Untersuchungen in einem Raster-Elektronenmikroskop ist in der Figur dargestellt.

Eine zerstörungsfreie Untersuchung von integrierten Schaltungen IC mit induzierten Strömen ist nur mit einem Laser Scanner oder einem Flying-Spot Scanner möglich. Bei diesen Geräten wird ein rasternder Lichtpunkt L auf die integrierte Schaltung IC abgebildet. Bei einem erfindungsgemäßen Flying-Spot Scanner wird der rasternde Elektronenstrahl R eines marktüblichen Raster-Elektronenmikroskops auf einen Szintillator S fokussiert, welcher Szintillator S seinerseits als Lichtquelle innerhalb des kommerziellen Raster-Elektronenmikroskops dient. Das vom Szintillator S emittierte Licht wird über ein optisches System O auf die integrierte Schaltung IC abgebildet. Die Ausgestaltung des optischen Systems O kann mit sehr einfachen Mitteln erfolgen, welche dem Fachmann geläufig sind.

Welche Untersuchungen oder Betriebsarten mit einem Flying-Spot Scanner möglich sind, kann dem Stand der Technik über Flying-Spot Scanner bzw. Laser Scanner entnommen werden. Ein Flying-Spot Scanner ist beispielsweise von C.N. Potter et al in The Review of Scientific Instruments,

0107034
82 P 1838 E

Vol.39, No.2, 1968, 180-183 beschrieben. Ein Laser Scanner ist beispielsweise von D.E. Sawyer et al in Proc. Letters, Proc. of the IEEE, March 1976, 393-394 beschrieben. Beispielsweise kann die Oberfläche einer zu untersuchenden integrierten Schaltung IC mit dem rasternden Lichtpunkt L abgetastet werden und gleichzeitig das in der integrierten Schaltung IC induzierte Signal verstärkt und aufgezeichnet werden. Die Darstellung des in der integrierten Schaltung IC induzierten Signals kann beispielsweise mit Hilfe eines Video-Verstärkers erfolgen. Eine Interpretation des induzierten Signals liefert die gewünschte Information über das zu untersuchende Objekt. Mit einem erfindungsgemäßen Flying-Spot Scanner kann eine Reihe von Phänomenen untersucht werden, die bei einer integrierten Schaltung IC auftreten können. Beispielsweise können Gleichströme oder Wechselströme an bestimmten Meßpunkten induziert werden und das dadurch hervorgerufene Signal an einem anderen Meßpunkt detektiert werden. Dieses dadurch hervorgerufene Signal an dem anderen Meßpunkt kann beispielsweise mit einem Elektronenstrahl, bei entsprechender Ausgestaltung auch mit dem rasternden Elektronenstrahl R, abgetastet werden. Dynamische Vorgänge in einem integrierten Schaltkreis IC können stroboskopisch mit Hilfe des rasternden Lichtpunkts L verfolgt werden. Weiter können interne logische Zustände innerhalb einer integrierten Schaltung IC zerstörungsfrei dadurch geändert werden, daß die Intensität des rasternden Lichtpunkts L über eine Steigerung der Intensität des rasternden Elektronenstrahls R kurzzeitig erhöht wird.

Die Erfindung verbessert die Untersuchungsmöglichkeiten von integrierten Schaltungen IC bei sehr geringem zusätzlichen Aufwand zu den heute gebräuchlichen Hilfsmitteln zur Untersuchung von integrierten Schaltungen IC.

Aus einem marktüblichen Raster-Elektronenmikroskop kann
eine erfindungsgemäße Vorrichtung erstellt werden, bei
der der rasternde Lichtpunkt L Dimensionen abrastern
kann, die für die Meßpunkte einer integrierten Schaltung IC typisch sind, ohne daß das optische System 0 verkleinernd wirken muß.

0107034
82 P 1838 E

Patentansprüche:

1. Flying-Spot Scanner für lichtmikroskopische Untersuchungen, dadurch g e k e n n z e i c h n e t , daß
der Elektronenstrahl (R) eines Raster-Elektronenmikroskops auf einen Szintillator (S) gerichtet ist, und daß
das vom Szintillator (S) emittierte Licht (L) über ein
optisches System (O) auf einen zu untersuchenden Prüfpunkt (IC) abgebildet ist.

2. Verfahren zum Betrieb eines Flying-Spot Scanners
nach Anspruch 1, dadurch g e k e n n z e i c h n e t ,
daß in einem zu untersuchenden Objekt (IC) ein Strom
durch Licht (L) induziert wird.

3. Verfahren zum Betrieb eines Flying-Spot Scanners
nach Anspruch 1, g e k e n n z e i c h n e t durch eine
Fehleranalyse eines zu untersuchenden Objekts (IC) ähnlich einem EBIC (EBIC = Potentialmessung mittels elektronenstrahl-induziertem Strom)-Verfahren.

4. Verfahren zum Betrieb eines Flying-Spot Scanners
nach Anspruch 1, dadurch g e k e n n z e i c h n e t ,
daß ein Strom an einem Meßpunkt (IC) induziert wird und
daß das dadurch hervorgerufene Signal an einem anderen
Meßpunkt detektiert wird.

5. Verfahren zum Betrieb eines Flying-Spot Scanners
nach Anspruch 4, dadurch g e k e n n z e i c h n e t ,
daß das Signal an dem anderen Meßfleck mit einem Elektronenstrahl abgetastet wird.

6. Verfahren zum Betrieb eines Flying-Spot Scanners
nach Anspruch 1, dadurch g e k e n n z e i c h n e t ,

daß ein logischer Zustand innerhalb einer logischen Schaltung (IC) durch kurzzeitige Erhöhung der Intensität des rasternden Lichtpunkts (L) über eine kurzzeitige Erhöhung der Intensität des rasternden Elektronenstrahls (R) geändert wird.